# EUROPEAN PATENT APPLICATION

(11) **EP 4 709 111 A1**
(43) Date of publication of application: **11.03.2026**
(21) Application number: 25198630.3
(22) Date of filing: 28.08.2025
(51) Int. Cl.: H10H 29/24, G03F 7/00

(54) **LIGHT SOURCE APPARATUS, EXPOSURE APPARATUS, AND ARTICLE MANUFACTURING METHOD**

(30) Priority: 30.08.2024 JP 2024150231
(71) Applicant: Canon Kabushiki Kaisha, Tokyo, 146-8501 (JP)
(72) Inventor: SAITO, Mahiro, Tokyo, 146-8501 (JP)
(74) Representative: TBK

(57) **Abstract**

A light source apparatus includes an element array in which a plurality of light emitting elements are arrayed, wherein the plurality of light emitting elements include a first light emitting element, and a second light emitting element having temperature characteristic, which indicates a relationship between an element temperature and a peak wavelength, different from a temperature characteristic of the first light emitting element, and the first light emitting element and the second light emitting element are arrayed in accordance with temperature unevenness in the element array.

## Description

### TECHNICAL FIELD

The present disclosure relates to a light source apparatus, an exposure apparatus, and an article manufacturing method.

### BACKGROUND

An exposure apparatus is an apparatus that transfers a pattern formed in an original to a substrate. The exposure apparatus illuminates the original with light via an illumination optical system, and projects the image of the pattern of the original onto the substrate via a projection optical system. A mercury lamp has been conventionally used as an exposure light source, but in these years, it is expected to be replaced by a light emitting diode (LED) which is a light emitting element. The LED is energy-efficient and has a long life because it takes a short time until light output is stabilized after a current flows through a circuit configured to control light emission, so need not emit light constantly, unlike a mercury lamp.

Since the luminance of one LED is lower than the luminance of one mercury lamp, as the light source, it is necessary to use an LED array in which a plurality of LEDs are arrayed. The higher the degree of integration of the LED array, or the higher the input power, the greater the total amount of heat generated by the LED array. As the temperature of the LED increases, a phenomenon occurs in which the peak wavelength or dominant wavelength of the emission wavelength characteristic shifts to the longer wavelength side (temperature dependency). Therefore, when temperature unevenness occurs among the plurality of LEDs due to individual control of the current values of the plurality of LEDs, variation in peak wavelength (wavelength unevenness) occurs.

Japanese Patent Laid-Open No. 2024-035053 discloses a surface light emitting apparatus in which a plurality of light emitting elements are arranged in a plane. The surface light emitting apparatus in Japanese Patent Laid-Open No. 2024-035053 includes a first light emitting element arranged on the outer periphery, and a second light emitting element arranged inside thereof, and the first light emitting element and the second light emitting element output light beams having different peak wavelengths. With this, color unevenness is reduced.

### SUMMARY

When a plurality of LEDs are used as the light source of an exposure apparatus, the wavelength unevenness caused by the temperature dependency can affect illuminance uniformity and resolution. Therefore, it is desired to reduce wavelength unevenness. However, the technique disclosed in Japanese Patent Laid-Open No. 2024-035053 cannot reduce wavelength unevenness.

The present disclosure provides a technique advantageous for reducing the wavelength unevenness caused by the temperature unevenness among a plurality of light emitting elements.

The present disclosure in its first aspect provides a light source apparatus as specified in claim 1. Optional features are specified in claim 2 to 9.

The present disclosure in its second aspect provides an exposure apparatus as specified in claim 10.

The present disclosure in its third aspect provides an article manufacturing method as specified in claim 11.

Features of the present disclosure will become apparent from the following description of embodiments with reference to the attached drawings. The following description of embodiments are described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
Fig. 1 is a view showing the arrangement of a light source apparatus;
Fig. 2 is a graph showing the temperature-peak wavelength characteristics of light emitting elements;
Fig. 3 is a view for explaining the array of a plurality of light emitting elements in an element array;
Figs. 4A and 4B are views showing the arrangement of an element array;
Fig. 5 is a view for explaining the heat sink flow path and the array of a plurality of light emitting elements in the element array; and
Fig. 6 is a view showing the arrangement of an exposure apparatus.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

### <First Embodiment>

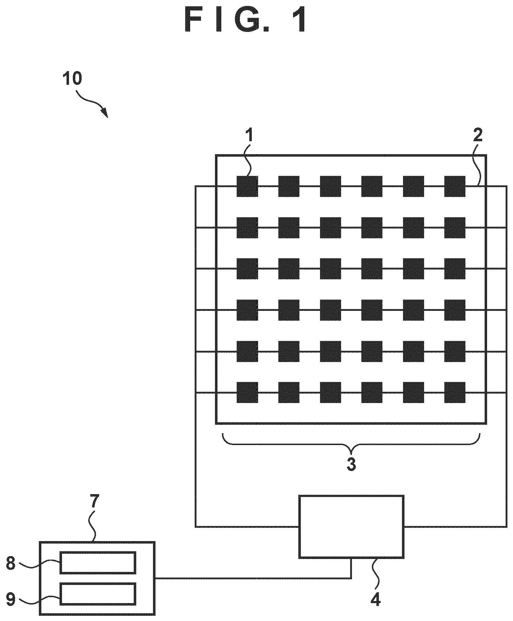

Fig. 1 is a view showing the arrangement of a light source apparatus 10 according to the first embodiment. The light source apparatus 10 can include an element array 3 in which a plurality of light emitting elements 1 are arranged in a matrix, a power supply 4, and a controller 7. Each of the plurality of light emitting elements 1 is formed from an LED. The light emission amount of the element array 3 in this embodiment is variable.

Since the radiant energy of one light emitting element 1 is smaller than that of a mercury lamp, it is necessary to use the plurality of light emitting elements 1. The plurality of light emitting elements 1 are arranged in a matrix. The number of the light emitting elements 1 can be, for example, about 1,000, but is not limited to a particular number. In Fig. 1, for the sake of convenience, the plurality of light emitting elements 1 are arranged to form a 6×6 matrix. Here, the horizontal direction corresponds to the row, and the vertical direction corresponds to the column. In Fig. 1, the plurality of light emitting elements 1 are arrayed in a square matrix, but not limited to this. For example, they may be arranged in zigzag. Each of the plurality of light emitting elements 1 can be a UV-LED element that emits ultraviolet light. If each of the plurality of light emitting elements 1 is a UV-LED element, the nominal emission peak wavelength is, for example, 365 nm, 385 nm, 405 nm, or the like.

The plurality of light emitting elements 1 are connected to each other by lead wires 2 to form a circuit. In the example shown in Fig. 1, the light emitting elements 1 in each row are connected in series by the lead wire 2, and each row is connected to the power supply 4 in parallel. When a current flows through the circuit, each of the light emitting elements 1 outputs light. In the example shown in Fig. 1, when a current is supplied from the power supply 4 to the light emitting elements 1 in respective columns via the lead wires 2, each of the light emitting elements 1 emits light. At this time, each of the plurality of light emitting elements 1 can generate heat. In general, the package type of the element array 3 having this arrangement is also called Chip On Board (COB). Since a large number of light emitting elements (LED chips) can be integrated, COB has an advantage that it can provide a large amount of light.

The controller 7 can be formed by a general-purpose or dedicated computer installed with a program, or a combination of all or some of these components. The controller 7 can include, for example, a processor 8 and a storage 9. The processor 8 decides a current value to be supplied to each row of the element array 3, and drives the power supply 4. In the arrangement shown in Fig. 1, the power supply 4 cannot individually drive the plurality of light emitting elements 1 in the element array 3, but can drive them to be lit up on a row basis.

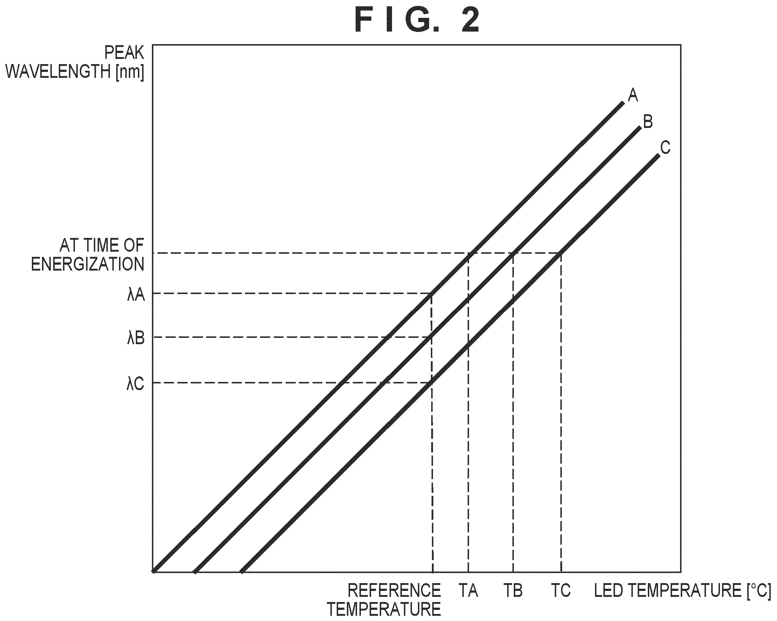

The LED used as the light emitting element has the temperature dependency in which the peak wavelength or dominant wavelength of light emitted from the LED changes in accordance with the element temperature of the LED. The plurality of light emitting elements 1 can include a first light emitting element A, a second light emitting element B, and a third light emitting element C having different temperature characteristics (temperature-peak wavelength characteristics) that indicate the relationship between the element temperature and the peak wavelength. Fig. 2 is a graph showing the temperature-peak wavelength characteristics of the first light emitting element A, the second light emitting element B, and the third light emitting element C. In Fig. 2, the abscissa represents the temperature of the light emitting element (LED), and the ordinate represents the peak wavelength of the light emitting element. According to Fig. 2, the peak wavelengths of the first light emitting element A, the second light emitting element B, and the third light emitting element C at a reference temperature (for example, 23°C) are λA, λB, and λC, respectively.

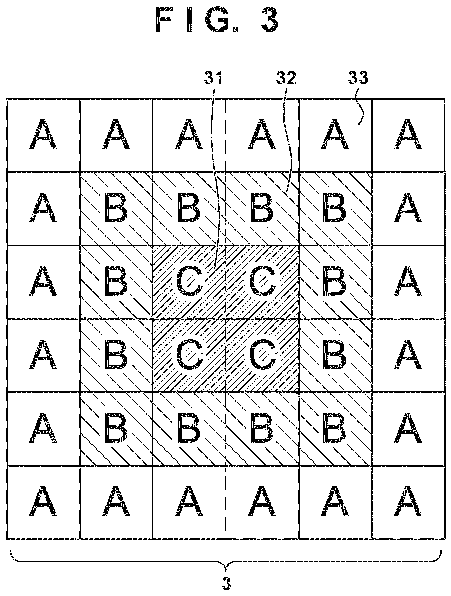

With reference to Fig. 3, an example of the arrangement of the first light emitting elements A, the second light emitting elements B, and the third light emitting elements C in the element array 3 will be described. Fig. 3 is a view schematically showing the light emitting surface in the element array 3. The element array 3 can have a central region 31 including the center of the light emitting surface of the element array 3, a first outer peripheral region 32 surrounding the central region 31, and a second outer peripheral region 33 surrounding the first outer peripheral region 32. The second outer peripheral region 33 is located on the outermost periphery of the element array 3. Note that only one outer peripheral region surrounding the central region 31 may be defined without distinguishing the first outer peripheral region 32 and the second outer peripheral region 33. The first outer peripheral region 32 may be further divided into a plurality of regions.

According to the characteristics shown in Fig. 2, when a current is flowing through the first light emitting element A, the second light emitting element B, and the third light emitting element C (during energization), the temperatures (average temperatures) of the first light emitting element A, the second light emitting element B, and the third light emitting element C are TA, TB, and TC, respectively. Note that TA < TB < TC. In other words, if a current flows when the temperatures of the first light emitting element A, the second light emitting element B, and the third light emitting element C are TA, TB, and TC, respectively, the light beams output from the first light emitting element A, the second light emitting element B, and the third light emitting element C have the same wavelength.

The element array 3 in which the light emitting elements are integrated has a tendency that the temperature of the region surrounded by a larger number of heat generation bodies (light emitting elements) becomes higher. For example, the temperature of the central region 31 becomes higher than the temperature of the first outer peripheral region 32, and the temperature of the first outer peripheral region 32 becomes higher than the temperature of the second outer peripheral region 33. In this manner, when temperature unevenness (temperature distribution) occurs in the element array 3, wavelength unevenness can occur among the plurality of light emitting elements.

To prevent this, in this embodiment, the light emitting elements are arrayed in accordance with the temperature unevenness (the temperature distribution) in the element array 3. That is, the light emitting element having a long peak wavelength at the reference temperature is arranged in the region having a low temperature, and the light emitting element having a short peak wavelength at the reference temperature is arranged in the region having a high temperature. More specifically, as shown in Fig. 3, the first light emitting element A having the peak wavelength λA at the reference temperature is arranged in the second outer peripheral region 33. The second light emitting element B having the peak wavelength λB at the reference temperature is arranged in the first outer peripheral region 32. Furthermore, the third light emitting element C having the peak wavelength λC at the reference temperature is arranged in the central region 31. With this, the peak wavelengths of the first light emitting element A, the second light emitting element B, and the third light emitting element C during energization can be aligned.

In this manner, in the example described above, among the first light emitting element A, the second light emitting element B, and the third light emitting element C, the third light emitting element C having the shortest peak wavelength at the reference temperature is arranged in the central region 31. The second light emitting element B having the second shortest peak wavelength at the reference temperature is arranged in the first outer peripheral region 32, and the first light emitting element A having the longest peak wavelength at the reference temperature is arranged in the second outer peripheral region 33.

Note that if the first light emitting element A, the second light emitting element B, and the third light emitting element C are UV-LEDs, they are preferably set to have the temperature-wavelength characteristics with which the peak wavelengths during energization fall within a predetermined allowable range (for example, a range of 366 nm ± 2 nm). Alternatively, the predetermined allowable range is more preferably a range of, for example, 366 nm ± 1 nm.

In the example described above, a case has been described where the plurality of light emitting elements 1 include three kinds of light emitting elements having temperature characteristics different from each other. To the contrary, in a case where the plurality of light emitting elements 1 include only two kinds of light emitting elements (for example, the first light emitting element A and the second light emitting element B) having temperature characteristics different from each other, only the central region and the outer peripheral region are defined without distinguishing the first outer peripheral region 32 and the second outer peripheral region 33. In this case, one of the first light emitting element A and the second light emitting element B that has a shorter peak wavelength at the reference temperature is arranged in the central region, and the other is arranged in the outer peripheral region.

With the arrangement described above, even in a state in which there is temperature unevenness in the element array 3 during energization, the wavelength unevenness among the plurality of light emitting elements can be reduced.

### <Second Embodiment>

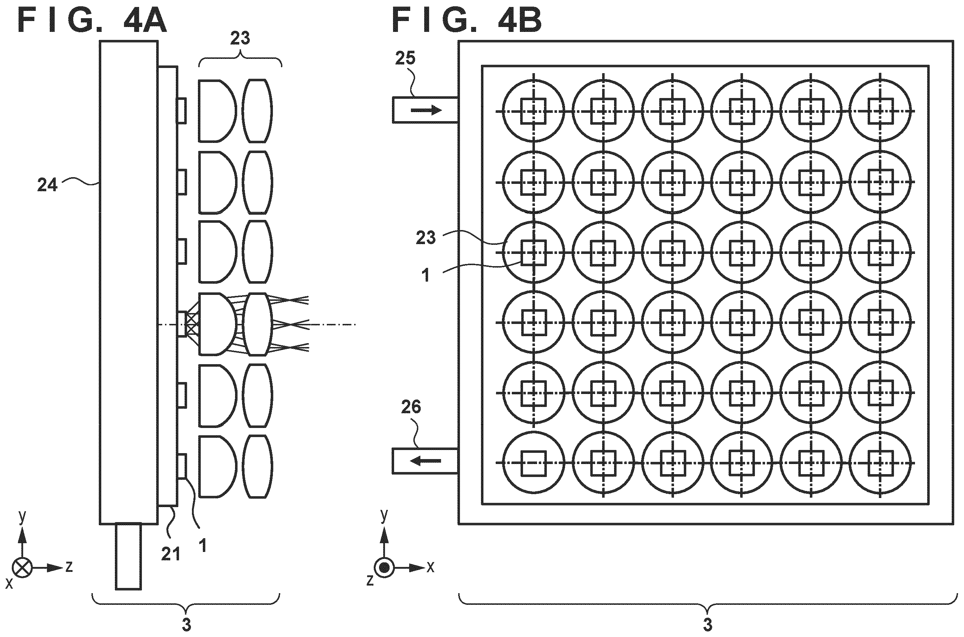

Figs. 4A and 4B are views showing the arrangement of an element array 3 according to the second embodiment. Fig. 4A is a schematic view of a section of the element array 3 when viewed from the x direction, and Fig. 4B is a schematic view of the element array 3 when viewed from the z direction. A plurality of light emitting elements 1 are arrayed in the x and y directions in a matrix on a base 21.

The light emitted from the plurality of light emitting elements 1 has a radiation angle of about 60 to 70° in a half angle, which is a very large angular distribution considering that a numerical aperture NA of a projection optical system for a general flat panel display is about 0.1 (equivalent to an angle of about 5.7°). Therefore, in order to capture the light flux emitted from the plurality of light emitting elements 1 by a downstream optical system without loss, a light condenser 23 can be arranged for collimating the emitted light flux directly above each of the plurality of light emitting elements 1. The light condenser 23 is provided with collimating lenses so as to correspond to the light emitting elements 1. In Fig. 4B, the intersection point of alternate long and short dashed lines represents the optical axis of each collimating lens included in the light condenser 23.

In a UV-LED element, only about 30% to 50% of the input power can be used as the desired light, and the remaining portion is converted into heat. Therefore, in order to suppress the temperature changes of the plurality of light emitting elements 1, a cooler 24 is provided. The cooler 24 is, for example, a liquid cooling heat sink. In this case, the cooler 24 has a heat sink flow path which is disposed to pass near each of the plurality of light emitting elements 1 and through which a coolant flows. A coolant adjusted to a predetermined temperature is supplied from a supply unit 25 to the heat sink flow path. As the coolant flows through the heat sink flow path, the coolant absorbs the heat transferred from the light emitting element 1 via the base 21, thereby cooling the light emitting element 1. The coolant having absorbed the heat from the light emitting element 1 is recovered via a recovery unit 26. The recovered coolant is cooled by an adjustment unit (not shown) and is supplied to the cooler 24 again.

Parameters related to cooling (cooling conditions) include the flow velocity of the coolant and the temperature of the coolant. As the flow velocity of the coolant increases or the temperature of the coolant decreases, the cooling performance improves, and more heat can be removed from the light emitting element 1. In general, the temperature of the coolant can be set to be close to the environmental temperature (room temperature) of the light source apparatus 10. Since the room temperature in a clean room for manufacturing semiconductors/FPDs is generally about 22°C to 24°C, a temperature included in this temperature range can be the environmental temperature or room temperature.

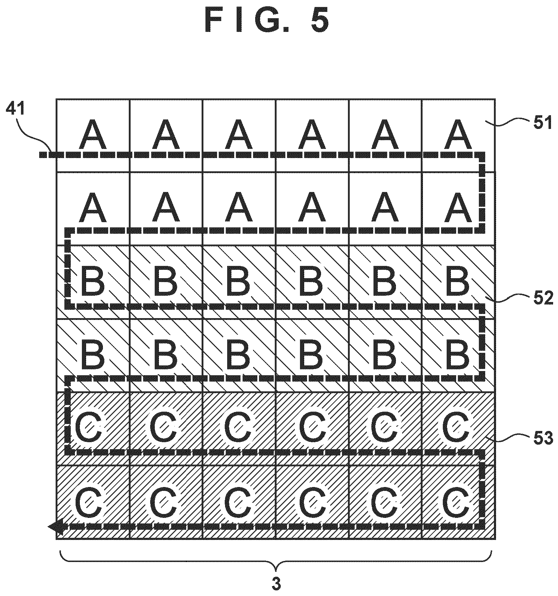

Fig. 5 shows an example of a heat sink flow path 41 forming the cooler 24. The heat sink flow path 41 is arranged to meander near each of the plurality of light emitting elements 1, for example, from the upper left position to the lower left position in the element array 3. One end of the heat sink flow path 41 at the upper left position in the element array 3 is fluid-connected to the supply unit 25, and the other end of the heat sink flow path 41 at the lower left position in the element array 3 is fluid-connected to the recovery unit 26. In the heat sink flow path 41 shown in Fig. 5, a region including two upper rows of the 6×6 matrix of the plurality of light emitting elements 1 is defined as an upstream area 51, a region including two lower rows is defined as a downstream area 53, and a region including two middle rows between the upstream area and the downstream area is defined as a midstream area 52. Note that only the upstream area 51 and the downstream area 53 may be defined without the midstream area 52. The temperature of the coolant flowing through the heat sink flow path 41 increases as the coolant flows from the upstream area 51 to the midstream area 52 and then to the downstream area 53.

According to the characteristics shown in Fig. 2, during energization, the temperature of a first light emitting element A is TA, the temperature of a second light emitting element B is TB higher than TA, and the temperature of a third light emitting element C is TC higher than TB. Therefore, in the second embodiment, as shown in Fig. 5, the first light emitting element A having a peak wavelength λA at a reference temperature is arranged in the upstream area 51. The second light emitting element B having a peak wavelength λB at the reference temperature is arranged in the midstream area 52. Furthermore, the third light emitting element C having a peak wavelength λC at the reference temperature is arranged in the downstream area 53. With this, the peak wavelengths of the first light emitting element A, the second light emitting element B, and the third light emitting element C during energization can be aligned.

In this manner, in the example described above, among the first light emitting element A, the second light emitting element B, and the third light emitting element C, the light emitting element having the longest peak wavelength at the reference temperature is arranged in the upstream area of the flow path, the light emitting element having the second longest peak wavelength is arranged in the midstream area of the flow path, and the light emitting element having the shortest peak wavelength is arranged in the downstream area of the flow path.

In the example described above, a case has been described where the plurality of light emitting elements 1 include three kinds of light emitting elements having temperature characteristics different from each other. To the contrary, in a case where the plurality of light emitting elements 1 include only two kinds of light emitting elements (for example, the first light emitting element A and the second light emitting element B) having temperature characteristics different from each other, the matrix of the plurality of light emitting elements 1 is defined by only two flow areas, that is, the upstream area and the downstream area. In this case, one of the first light emitting element A and the second light emitting element B that has a longer peak wavelength at the reference temperature is arranged on the upstream side of the flow path, and the other is arranged on the downstream side of the flow path.

With the arrangement described above, even in a state in which there is temperature unevenness (temperature distribution) in the element array 3 due to the temperature transition of the coolant, the wavelength unevenness among the plurality of light emitting elements can be reduced.

### <Third Embodiment>

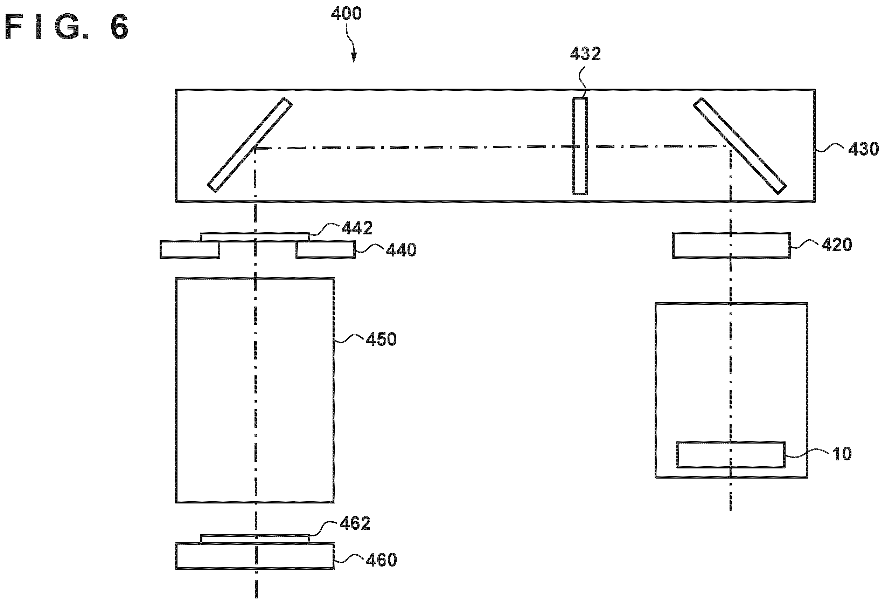

Fig. 6 shows the arrangement of an exposure apparatus 400 according to the third embodiment. The exposure apparatus 400 is an exposure apparatus using the light source apparatus 10 according to the first embodiment or the second embodiment described above. The exposure apparatus 400 can include, for example, a light source apparatus 10, a shutter apparatus 420, an illumination optical system 430, an original holder 440, a projection optical system 450, and a substrate holder 460. The illumination optical system 430 can include an i-line band filter 432. The original holder 440 holds an original 442. The original holder 440 can be positioned by an original positioning mechanism (not shown), thereby positioning the original 442. The substrate holder 460 holds a substrate 462. The exposure apparatus 400 is supplied with the substrate 462 on which a resist (photosensitive material) has been applied by a resist application apparatus. The substrate holder 460 can be positioned by a substrate positioning mechanism (not shown), thereby positioning the substrate 462. The shutter apparatus 420 is arranged such that it can block a light flux in an optical path between the light source apparatus 10 and the original holder 440. Blocking the light flux may be substituted by stopping light emission of the LED in the light source apparatus 10. The illumination optical system 430 illuminates the original 442 using light from the light source apparatus 10. The projection optical system 450 projects the pattern of the original 442 illuminated by the illumination optical system 430 onto the substrate 462, thereby exposing the substrate 462. With this exposure, a latent pattern is formed in the resist applied to the substrate 462. The latent pattern is developed by a developing apparatus (not shown), and a resist pattern is thus formed on the substrate 462.

The projection optical system 450 uses an imaging optical system. Therefore, if the peak wavelengths of a plurality of light emitting elements 1 vary in the light source apparatus 10, the pattern imaging performance on the substrate 462 is degraded since the refractive index of a lens changes depending on the wavelength. In addition, the i-line band filter 432 cuts the peak wavelength of the light from the light source apparatus 10 to a wavelength width according to the lens performance. Hence, if wavelength unevenness occurs in the light source apparatus, the peak wavelength of the composite light spreads and the illuminance decreases. For example, when the half-width of the i-line band filter 432 is 10 nm, if a wavelength drift of 1 nm occurs, approximately 10% of light is cut.

To prevent degradation of the imaging performance of the projection optical system 450, the wavelength variation among the plurality of light emitting elements 1 in the light source apparatus is preferably ± 1 nm or less. The light source apparatus 10 uses an LED in place of a UV lamp. Accordingly, in an optical system designed for a UV lamp, considering the wavelength of the UV lamp, the wavelength during energization preferably falls within a range of 366 nm ± 1 nm.

By using the light source apparatus according to the first or second embodiment described above, excellent resolution and illuminance can be implemented.

### <Embodiment of Article Manufacturing Method>

An article manufacturing method according to the embodiment of the present disclosure is suitable for manufacturing an article, for example, a microdevice such as a semiconductor device or an element having a microstructure. The article manufacturing method according to this embodiment includes a step of forming a latent pattern in a photosensitive agent applied to a substrate by using the above-described exposure apparatus (a step of exposing a substrate), and a step of developing the substrate with the latent pattern formed thereon in the preceding step. The manufacturing method further includes other known steps (oxidation, film formation, deposition, doping, planarization, etching, resist removal, dicing, bonding, packaging, and the like). The article manufacturing method of this embodiment is more advantageous than the conventional methods in at least one of the performance, quality, productivity, and production cost of the article.

According to the present disclosure, a technique advantageous for reducing the wavelength unevenness caused by the temperature unevenness among a plurality of light emitting elements is provided.

Various embodiments have been described in detail above but it will be understood that the present disclosure is not limited to these embodiments and encompasses all modifications, variants, alternatives and equivalents falling within the scope of the appended claims.

## Claims

1. A light source apparatus (10) **characterized by** comprising:
an element array (3) in which a plurality of light emitting elements (1) are arrayed,
wherein the plurality of light emitting elements include:
a first light emitting element (A), and
a second light emitting element (B) having temperature characteristic, which indicates a relationship between an element temperature and a peak wavelength, different from a temperature characteristic of the first light emitting element, and
the first light emitting element and the second light emitting element are arrayed in accordance with temperature unevenness in the element array.

2. The apparatus according to claim 1, **characterized in that**
the element array includes a central region (3) including a center of a light emitting surface of the element array, and an outer peripheral region (32, 33) surrounding the central region, and
one of the first light emitting element and the second light emitting element, that has a shorter peak wavelength at a reference temperature, is arranged in the central region, and the other is arranged in the outer peripheral region.

3. The apparatus according to claim 1, **characterized in that**
the plurality of light emitting elements further include a third light emitting element (C) having temperature characteristic different from the temperature characteristic of each of the first light emitting element and the second light emitting element,
the element array has a central region (31) including a center of a light emitting surface of the element array, a first outer peripheral region (32) surrounding the central region, and a second outer peripheral region (33) surrounding the first outer peripheral region, and
among the first light emitting element, the second light emitting element, and the third light emitting element, the light emitting element having a shortest peak wavelength at a reference temperature is arranged in the central region, the light emitting element having a second shortest peak wavelength at a reference temperature is arranged in the first outer peripheral region, and the light emitting element having a longest peak wavelength at a reference temperature is arranged in the second outer peripheral region.

4. The apparatus according to claim 1, **characterized by** further comprising
a cooler (24) having a flow path which is disposed to pass near each of the plurality of light emitting elements and through which a coolant flows,
wherein one of the first light emitting element and the second light emitting element that has a longer peak wavelength at a reference temperature is arranged on an upstream side of the flow path, and the other is arranged on a downstream side of the flow path.

5. The apparatus according to claim 1, **characterized by** further comprising
a cooler (24) having a flow path which is disposed to pass near each of the plurality of light emitting elements, and through which a coolant flows,
wherein the plurality of light emitting elements further include a third light emitting element (C) having the temperature characteristic different from the temperature characteristic of each of the first light emitting element and the second light emitting element, and
among the first light emitting element, the second light emitting element, and the third light emitting element, the light emitting element having a longest peak wavelength at a reference temperature is arranged in an upstream area of the flow path, the light emitting element having a second longest peak wavelength at a reference temperature is arranged in a midstream area of the flow path, and the light emitting element having a shortest peak wavelength at a reference temperature is arranged in a downstream area of the flow path.

6. The apparatus according to claim 1, **characterized in that**
in a state in which the first light emitting element and the second light emitting element are arrayed in accordance with temperature unevenness in the element array, a difference between a peak wavelength of the first light emitting element and a peak wavelength of the second light emitting element during energization falls within a predetermined allowable range.

7. The apparatus according to claim 6, **characterized in that**
each of the plurality of light emitting elements is a UV-LED element that emits ultraviolet light, and
a wavelength variation among the plurality of light emitting elements is ± 1 nm or less.

8. The apparatus according to claim 6, **characterized in that**
each of the plurality of light emitting elements is a UV-LED element that emits ultraviolet light, and
the predetermined allowable range is a range of 366 nm ± 2 nm.

9. The apparatus according to claim 7, **characterized in that**
the predetermined allowable range is a range of 366 nm ± 1 nm.

10. An exposure apparatus **characterized by** comprising:
an illumination optical system configured to illuminate an original with light from a light source apparatus defined in any one of claims 1 to 9; and
a projection optical system configured to project a pattern of the original illuminated by the illumination optical system onto a substrate.

11. An article manufacturing method **characterized by** comprising:
exposing a substrate using an exposure apparatus defined in claim 10; and
developing the exposed substrate,
wherein an article is manufactured from the developed substrate.
